# EUROPEAN PATENT APPLICATION

(11) **EP 3 708 973 A1**
(43) Date of publication of application: **16.09.2020**
(21) Application number: 18875774.4
(22) Date of filing: 06.11.2018
(51) Int. Cl.: G01F 1/00, F17D 5/06, G01N 27/10

(54) **JOINT SYSTEM**

(30) Priority: 07.11.2017 JP 2017215052
(71) Applicant: Takasago Electric, Inc., Nagoya-shi, Aichi 458-8522 (JP)
(72) Inventor: SUGIURA Hiroyuki, Nagoya-shi Aichi 458-8522 (JP); HAYASHI Yutaka, Nagoya-shi Aichi 458-8522 (JP); NAITO Ken, Nagoya-shi Aichi 458-8522 (JP); INOUE Masaaki, Nagoya-shi Aichi 458-8522 (JP)
(74) Representative: Viering, Jentschura & Partner mbB Patent- und Rechtsanwälte
(86) International application number: PCT/JP2018/041194
(87) International publication number: WO 2019/093331

(57) **Abstract**

A joint system (1S) includes flow paths (11A, 11B) coupled to a fluid device (2) which handles a fluid, first and second electrodes (141, 142) separately provided to the flow paths (11A, 11B) to electrically make contact with the fluid in the flow paths (11A, 11B), and a detection circuit (10) which detects whether the fluid passing through the fluid device (2) is present or absent. The detection circuit (10) measures a degree of electrical conductivity between the flow paths (11A, 11B) by using the first and second electrodes (141, 142) and detects whether the fluid passing through the fluid device (2) is present or absent in accordance with the degree of electrical conductivity between the flow paths (11A, 11B).

## Description

### TECHNICAL FIELD

The present invention relates to a joint to be coupled to a flow path of a fluid device which handles a fluid.

### BACKGROUND ART

Conventionally, various industrial products having a flow path of a fluid such as a liquid have been known. Most of these industrial products include a valve, a switch valve, or the like for stopping a flow of a liquid, switching a flow path, or adjusting a flow rate. In particular, for example, in various analyzing devices and inspection devices handling chemical liquids, sample liquids, and so forth, since it is required to manage the flow rate of the liquid and the flow path with high accuracy, valves and switch valve with high precision are adopted (for example, refer to PTL 1).

As a valve or switch valve, one includes a valve body driven to advance and retreat by an electromagnetic force and a valve seat onto which this valve body is pressed. In this valve or the like, while the valve body is pressed onto the valve seat to close the flow path, when the valve body retreats from the valve seat, a gap occurs therebetween to open the flow path.

### CITATION LIST

### PATENT LITERATURE

PTL 1: Japanese Unexamined Patent Application Publication No. 2016-75300

### SUMMARY OF INVENTION

### TECHNICAL PROBLEM

However, the above-described conventional fluid devices such as valves, switch valves, and pumps have the following problems. That is, the liquid to be handled may have properties in which crystals tend to be deposited, and regular maintenance is required. On the other hand, if maintenance is insufficient, crystals are deposited on, for example, a seal surface at a location of contact between the valve seat and the valve body or the like to cause defective sealing, and there is a possibility of occurrence of troubles such as liquid leakage.

The present invention was made in view of the above-described conventional problems and is to provide a joint system which can easily detect an operating state of a fluid device.

### SOLUTION TO PROBLEMS

The present invention is directed to a joint system including
flow paths coupled to a fluid device which handles a fluid, and
electrodes separately provided to at least two of the flow paths to electrically make contact with the fluid in the flow paths, wherein
the system is configured so as to be able to measure a degree of electrical conductivity between fluids in different flow paths by using the electrodes separately provided to said at least two of the flow paths.

### ADVANTAGEOUS EFFECTS OF INVENTION

The joint system of the present invention is a system including the electrodes separately provided to said at least two of the flow paths. In this joint system, a degree of electrical conductivity between fluids in different flow paths can be measured by using the electrodes. If a flow or liquid leakage of a fluid is present between different flow paths, the degree of electrical conductivity between the fluids increases and, for example, an electrical resistance value between the fluids decreases. On the other hand, if fluids are interrupted between different flow paths, the above-described degree of electrical conductivity decreases and, for example, the electrical resistance value between the fluids increases.

In this manner, the joint system of the present invention is a system which facilitates measurement of a degree of electrical conductivity between fluids in different flow paths and is suitable for detection of an operating state of a fluid device.

### BRIEF DESCRIPTION OF DRAWINGS

FIG. 1 is a diagram depicting an example of attachment of a joint unit configuring a joint system in a first embodiment.
FIG. 2 is a perspective view depicting a cross-sectional structure of the joint unit in the first embodiment.
FIG. 3 is a diagram describing valve-opening operation of an electromagnetic valve in the first embodiment.
FIG. 4 is a block diagram of a detection circuit to be combined with the joint unit in the first embodiment.
FIG. 5 is a diagram depicting a joint unit having the detection circuit incorporated therein in the first embodiment.
FIG. 6 is a diagram depicting another joint unit in the first embodiment.
FIG. 7 is a diagram depicting an example of attachment of a joint configuring a joint system in a second embodiment.
FIG. 8 is a structural diagram of the joint in the second embodiment.
FIG. 9 is a descriptive diagram of a joint unit to be combined with a manifold in a third embodiment.
FIG. 10 is a perspective view of the joint unit in the third embodiment.
FIG. 11 is a cross-sectional view depicting the structure of a joint portion of the joint unit in the third embodiment.
FIG. 12 is a circuitry diagram depicting an equivalent circuit of an electrical route between electrodes in a fourth embodiment.
FIG. 13 is a graph depicting an AC signal, an intermediate signal, and a detection signal in the fourth embodiment.
FIG. 14 is a block diagram of a control unit in a fifth embodiment.
FIG. 15 is a graph depicting an AC signal, an intermediate signal, and a detection signal in the fifth embodiment.

### DESCRIPTION OF EMBODIMENTS

Fluid devices as targets to which the joint system of the present invention is applied include valves, switch valves such as three-way valves and four-way valves, and pumps which pump a fluid to a flow path or suck the fluid, as well as pipes and tubes having flow paths, and manifolds provided with a plurality of flow paths, and so forth. Furthermore, the pipes and tubes having flow paths may be linear single pipes, or branch pipes or collecting pipes having a branch point or merging point of flow paths.

A joint system of one preferred mode in the present invention has said at least two of the flow paths integrally provided, and includes a joint unit configured to be attachable to the fluid device.

When the joint unit having said at least two of the flow paths integrally provided is attached to the fluid device, the degree of electrical conductivity between fluids in different flow paths can be efficiently measured.

The joint system of one preferred mode in the present invention includes a circuit which detects whether a fluid passing through the fluid device is present or absent in accordance with the degree of electrical conductivity.

According to the joint system including the detecting circuit, by detecting whether the fluid passing through the fluid device is present or absent, a faulty operating state such as liquid leakage of the fluid device and so forth can be detected.

The joint system of one preferred mode in the present invention includes a circuit which detects an amount of the fluid passing through the fluid device in accordance with the degree of electrical conductivity.

The amount of the fluid depends on a cross section of a passage of the fluid in the fluid device, temporal occupancy of an open state when temporal switching is made by, for example, duty control or the like, between the open state and a closed state of the passage, or the like. The degree of electrical conductivity is considered to change depending on the cross section of the passage, the temporal occupancy of the open state, or the like. Therefore, the amount of the fluid can be detected based on the degree of electrical conductivity.

The flow path in the joint system of one preferred mode in the present invention has electrical insulation properties ensured with respect to the fluid, and the electrodes have electrical insulation properties ensured with respect to the fluid device.

In this case, the degree of electrical conductivity between the fluids can be measured with high accuracy.

### EMBODIMENTS

Embodiments of the present invention are specifically described by using the following embodiments.

### (First Embodiment)

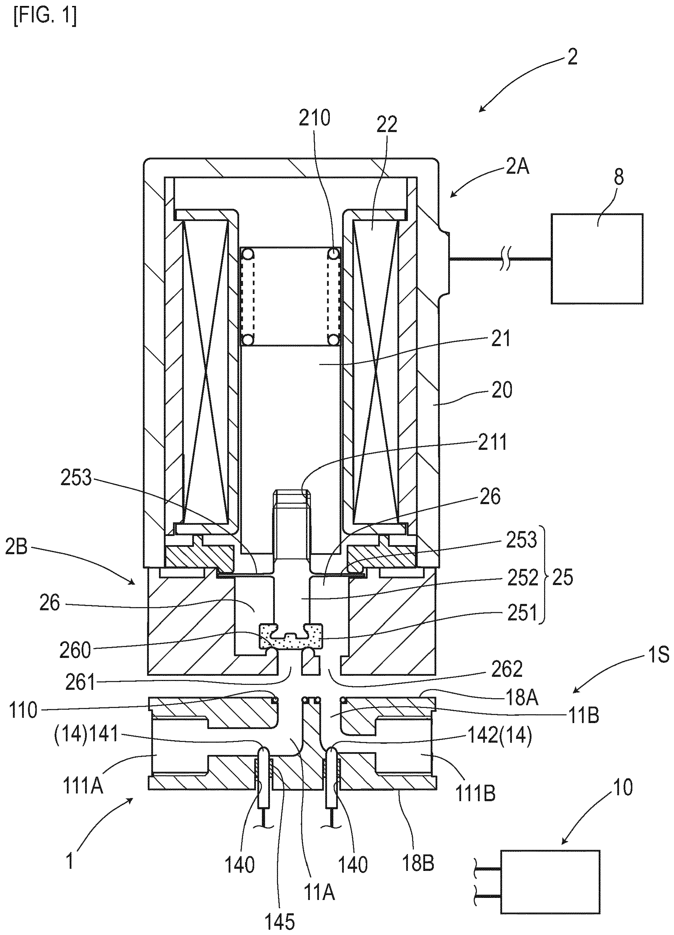

The present embodiment is an example in which a joint unit 1 configuring a joint system 1S is applied to an electromagnetic valve 2. Details of this are described with reference to FIG. 1 to FIG. 6.

The electromagnetic valve 2 embodying one example of a fluid device is provided with a valve seat 260 and a valve body 25 in midway of a flow path where a liquid (fluid) flows, and is a valve which is closed with the valve body 25 pressed onto the valve seat 260 and is opened with a gap occurring between the valve seat 260 and the valve body 25.

The joint unit 1 to be attached to this electromagnetic valve 2 includes a flow path 11A for supplying a liquid to the electromagnetic valve 2 and a flow path 11B for letting the liquid flow out from the electromagnetic valve 2. This joint unit 1 includes, as electrodes 14 for measuring a degree of electrical conductivity between a fluid on an inflow side and a fluid on an outflow side of the electromagnetic valve 2, a first electrode 141 electrically conductive to the liquid on the inflow side and a second electrode 142 electrically conductive to the liquid on the outflow side.

In the following, the structure of the electromagnetic valve 2 is first described, and then the details of the joint system 1S are described.

The electromagnetic valve 2 of FIG. 1 is a fluid device configured of a drive part 2A including a plunger 21 for driving the valve body 25 and a flow path part 2B having flow paths formed therein. The electromagnetic valve 2 operates by, for example, a drive signal outputted from an external drive unit 8.

The drive part 2A is configured with the columnar plunger 21 arranged and inserted inside a cylindrical coil 22 with a wire wound therearound. The coil 22 is fixed to inside of a metal-made, bottom-closed, cylindrical case 20. A winding end at each of both ends of the coil 22 is taken out to the outside of the case 20 so as to be able to be connected to, for example, the drive unit 8 fixed to the outside of the case 20.

The plunger 21 is a columnar part made of a ferromagnetic material. This plunger 21 is incorporated so as to be coaxial with respect to a cylindrical spring 210 arranged in a compressed state on a bottom side of the case 20. The plunger 21 is in a state of being biased by a biasing force of this spring 210 to a protruding side in an axial direction. In a distal end face of the plunger 21, a screw hole 211 is bored to have the columnar valve body 25 screwed therein.

The valve body 25 is a part having a shaft portion 252 as a resin-molded product combined with a rubber-made seal member 251. The shaft portion 252 has a film-shaped flange 253 integrally formed at an intermediate portion in the axial direction, and has an attachment structure provided at its distal end, the attachment structure to which the seal member 251 is to be attached. The seal member 251 forms a disk shape, and has a surface opposite to the shaft portion 252 as a seal surface to be biased onto the valve seat 260. The whole valve body 25 including the seal member 251, the flange 253, and so forth is formed of non-conductive material.

The flange 253 of the valve body 25 is configured so as to have its outer circumferential part fixed in a fluid-tight manner between the drive part 2A and the flow path part 2B, when the flow path part 2B is attached to the drive part 2A. This flange 253 prevents liquid leakage to a drive part 2A side in an assembled state, and also functions so as to allow a displacement of the valve body 25 in the axial direction in accordance with elastic deformation.

The flow path part 2B has a low-profile, substantially columnar outer shape as depicted in FIG. 1, and is attached to an end face of the drive part 2A which has a substantially columnar shape similar to the flow path part 2B. This flow path part 2B is a resin-finished product made of non-conductive resin material. Of surfaces of the flow path part 2B, a surface on a side serving as an attachment surface for the drive part 2A is provided with a liquid chamber 26 bored therein as a substantially columnar hollow part. On the surface opposite to the flow path part 2B, a flow path 261 on the inflow side and a flow path 262 on the outflow side are open.

The flow path 261 on the inflow side communicates with the liquid chamber 26 via a cylindrical edge portion provided to stand near the center of the bottom surface of the liquid chamber 26. The cylindrical edge portion like a well casing functions as the valve seat 260 where the above-described valve body 25 is pressed. The flow path 262 on the outflow side is open at an eccentric position on an outer circumferential side of the valve seat 260 on the bottom surface of the liquid chamber 26.

The flow path part 2B and the valve body 25 are formed of non-conductive resin material or rubber material or the like. Therefore, the liquid in the flow path 261, the flow path 262, and the liquid chamber 26 is in a state of being insulated without being in electrical contact with an electromagnetic valve 2 side.

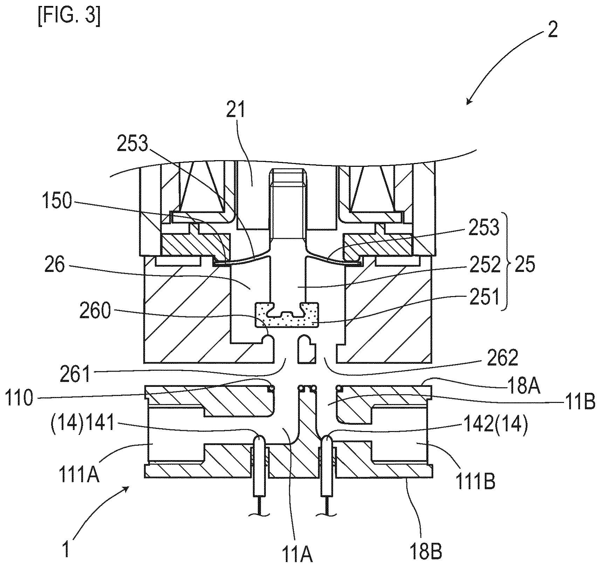

In the above-configured electromagnetic valve 2, the plunger 21 is electromagnetically driven in response to energization to the coil 22 by the drive unit 8, and retreats to a direction away from the flow path part 2B. With the plunger 21 retreating in this manner, the valve body 25 moves away from the valve seat 260 of the flow path part 2B to generate a gap, thereby bringing about a valve-open state in which the flow path 261 on the inflow side and the flow path 262 on the outflow side communicate via this gap (refer to FIG. 3). On the other hand, at the time of non-energization to the coil 22, the plunger 21 protrudes to a flow path part 2B side in the axial direction by the biasing force of the spring 210, thereby causing the valve body 25 to be pressed onto the valve seat 260 of the flow path part 2B to bring about a valve-closed state in which the flow path 261 on the inflow side and the flow path 262 on the outflow side are shut off. Note that at the time of this valve-closed state with the valve body 25 pressed onto the valve seat 260, the structure is such that the liquid is accumulated on an upstream side of the valve seat 260 and also accumulated to reside on a downstream side. Therefore, when the electromagnetic valve 2 is in the valve-closed state, the state becomes such that the first electrode 141 is immersed in the liquid on the inflow side and also the second electrode 142 is immersed in the liquid on the outflow side.

In the electromagnetic valve 2, at the time of the valve-closed state with the valve body 25 pressed onto the valve seat 260, the state becomes such that the liquid in the flow path 261 on the inflow side is electrically insulated from the liquid in the liquid chamber 26 and the liquid in the flow path 262 on the outflow side. On the other hand, at the time of the valve-open state with the valve body 25 away from the valve seat 260, the state becomes such that the liquid in the flow path 261 on the inflow side electrically makes contact with the liquid in the liquid chamber 26 and the liquid in the flow path 262 on the outflow side.

Next, the joint unit 1 and a detection circuit (circuit) 10 configuring the joint system 1S are described.

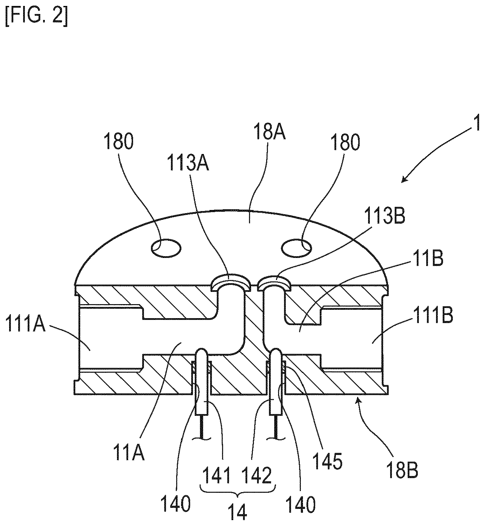

The joint unit 1 is, as in FIG. 1 and FIG. 2, a unit attached to the electromagnetic valve 2 or the like as a fluid device to form a joint to take flow paths out to the outside. The detection circuit 10 is a circuit which outputs a leak signal when the degree of electrical conductivity between the flow path 261 on the inflow side and the flow path 262 on the outflow side of the electromagnetic valve 2 is excessive. This detection circuit 10 is electrically connected via a signal line to the drive unit 8 which drives the joint unit 1 and the electromagnetic valve 2.

Note that as modes of combining the detection circuit 10 with the joint unit 1, a mode of attachment to the outside of the joint unit 1, a mode of providing a space inside the joint unit 1 for accommodation therein, a mode of combining the detection circuit 10 as a separate body, and others can be thought.

The joint unit 1 is, as in FIG. 1 and FIG. 2, a joint unit having an outer diameter approximately similar to that of the electromagnetic valve 2 and assuming a low-profile, substantially columnar outer shape. The joint unit 1 made of non-conductive resin material is attached to an end face of the electromagnetic valve 2 assuming a substantially columnar shape on the flow path part 2B side. On an attachment surface 18A of the joint unit 1 for the electromagnetic valve 2, the flow paths 11A and 11B on the inflow side and the outflow side to be coupled to the flow paths 261 and 262 on the electromagnetic valve 2 side are open, and through holes 180 so as to have fixing screws, not depicted, arranged in penetrating manner are provided. On opening portions of the flow paths 11A and 11B on the attachment surface 18A, seal parts 113A and 113B are formed, with their diameters enlarged so as to each have an O ring 110 arranged thereon.

On an outer circumferential surface of the joint unit 1, opening parts 111A and 111B of the flow paths 11A and 11B are provided at two locations positioned so as to be opposed to each other. On an inner circumferential surface of each of the opening parts 111A and 111B, a screw thread is formed to allow connection of plumbing not depicted. Note that the joint unit may have plumbing such as a silicone-made tube connected in advance.

In the joint unit 1, a flow path is formed by the flow path 11A on the inflow side forming one opening part 111A and the flow path 11B on the outflow side forming the other opening part 111B. In the joint unit 1, the flow path 11A on the inflow side and the flow path 11B on the outflow side that are open to the outer circumferential surface are bent at right angles to be open respectively to the attachment surface 18A as described above.

In the joint unit 1, attachment holes 140 at two locations communicating with the flow paths 11A and 11B, respectively, are provided to be bored in a surface 18B opposite to the attachment surface 18A for the electromagnetic valve 2. In each attachment hole 140, the electrode 14 is provided to be buried. The first electrode 141 penetrates through an inner circumferential wall surface of the flow path 11A on the inflow side to protrude inside the flow path 11A. The second electrode 142 penetrates through an inner circumferential wall surface of the flow path 11B on the outflow side to protrude inside the flow path 11B. Each electrode 14 is retained in the attachment hole 140 using a gasket 145 in a fluid-tight manner.

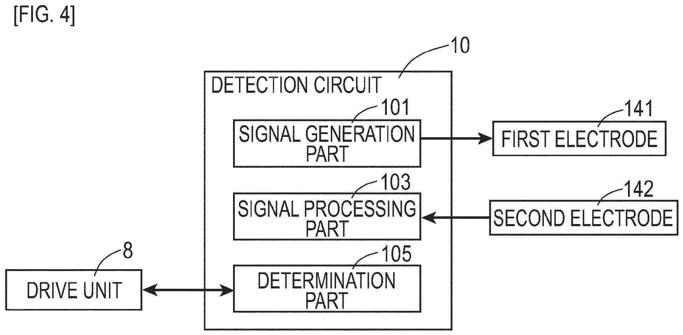

The detection circuit 10 (FIG. 4) is configured to include a signal generation part 101 which generates an AC signal, a signal processing part 103 which processes a detection signal, and a determination part 105 which determines liquid leakage. While applying the AC signal adjusted to have a predetermined voltage to the first electrode 141, the detection circuit 10 detects liquid leakage in accordance with a magnitude of a current occurring in the second electrode 142.

The signal generation part 101 is a circuit part which generates the AC signal at the predetermined voltage for application to the first electrode 141. As the AC signal, for example, a signal cyclically changing with a frequency of, for example, 1 KHz, or the like can be used. When the AC signal is applied to the electrode 141, electrolysis and crystal deposition that can occur at the electrode can be inhibited before they happen. In particular, if crystal deposition can avoid can be inhibited, accumulation of salt and so forth can be avoided, and accordingly changes in sensitivity characteristics of the electrode and so forth can be inhibited. Also, inhibition of electrolysis can inhibit changes in properties and so forth of the circulating liquid. In this manner, when electrolysis and crystal deposition that can occur at the electrode are inhibited before they happen by the application of the AC signal to the electrode 141, the occurrence of various troubles can be avoided before they happen.

Note that in the present embodiment, as the AC signal acting on the first electrode 141, an alternating square-wave (voltage) is adopted, in which a positive-value period and a negative-value period cyclically and alternately appear. As the AC signal, any of various signals can be adopted, such as a sine wave, triangular wave, and pulse wave. While the AC signal with a frequency of 1 kHz is adopted in the present embodiment, the frequency of the AC signal may be selectively set as appropriate. Also, when the AC signal with the predetermined voltage is applied, it is possible to inhibit influences such as fluctuations in power supply voltage being exerted on an output potential of the detection circuit 10, and detection accuracy can be improved. Note that expressions such as "an AC signal is acted onto the first electrode 141" or "a voltage is applied to the first electrode 141" mean that a voltage is applied between the first electrode 141 and the second electrode 142.

The signal processing part 103 is a circuit part which captures a current occurring at the second electrode 142 as the detection signal and converts the signal into the detection signal (voltage) that the determination part 105 can easily handle. Here, the current occurring at the second electrode 142 means a current flowing between the first electrode 141 and the second electrode 142 in accordance with a voltage applied between the first electrode 141 and the second electrode 142. When the above-described AC signal (voltage) is acted onto the first electrode 141, the signal processing part 103 has a function of amplifying the detection signal in alternating current(current) occurring at the second electrode 142, a function of converting the magnitude of the detection signal after amplification to a voltage value to generate an intermediate signal (AC voltage), and a function of generating the detection signal as one example of a measurement value indicating the magnitude of the amplitude of this intermediate signal. The function of generating the detection signal is achieved by the signal processing part 103 including a peak-hold circuit which holds a maximum value of the intermediate signal, a peak-hold circuit which holds a minimum value of the intermediate signal, and a differential circuit which generates a differential value between these maximum value and minimum value.

The signal processing part 103 provided with the above-described three functions acquires the intermediate signal of the AC voltage by current/voltage conversion based on the detection signal in alternating current(AC current) occurring at the second electrode 142, converts the intermediate signal to the detection signal with a DC voltage indicating the magnitude of the amplitude of that intermediate signal, and outputs that detection signal.

Note that the above-described function of generating the intermediate signal (AC voltage) may include a function of removing low-frequency components and high-frequency components by a band-pass filter. The frequential characteristics of this band-pass filter are preferably set so as to correspond to the frequency of the AC signal generated by the signal generation part 101. For example, when the AC signal cyclically changing with a frequency of 1 KHz is acted onto the electrode 141, a band-pass filter which selectively passes through signals of a frequency near 1 kHz is preferably adopted.

The determination part 105 is a circuit part which determines liquid leakage in a valve-closed period of the electromagnetic valve 2. The determination part 105 specifies the valve-closed period of the electromagnetic valve 2 by monitoring the drive signal of the drive unit 8 and also performs a threshold process regarding the detection signal (voltage value) obtained by conversion by the signal processing part 103. When the voltage value of the detection signal in the valve-closed period of the electromagnetic valve 2 exceeds the threshold value defined in advance, the determination part 105 makes a determination as liquid leakage. When making a determination as liquid leakage, the determination part 105 outputs a leak signal indicating that liquid leakage has been detected to the drive unit 8.

If the above-described joint system 1S including the joint unit 1 and the detection circuit 10 is combined with a fluid device such as the electromagnetic valve 2, liquid leakage under the valve-closed state can be detected in accordance with the degree of electrical conductivity between the liquid on the inflow side and the liquid on the outflow side of the electromagnetic valve 2. This joint system 1S is effective particularly when applied to a fluid device which handles a liquid where crystals are easily deposited. For example, in application to the electromagnetic valve 2, it is possible, for example, to detect, at an early stage, liquid leakage that can occur due to defective sealing caused by crystals deposited on the valve seat 260.

If maintenance of the electromagnetic valve 2 and so forth is performed in accordance with the occurrence of a leak signal indicating liquid leakage, it is possible to avoid worsening of a symptom of liquid leakage occurring at the valve seat 260, the valve body 25, and so forth, or a trouble or the like of an external device, not depicted, operating upon receiving supply of the liquid from the electromagnetic valve 2 before they happen.

Note that in the present embodiment, the structure is exemplarily described in which, at the time of the valve-closed state in which the valve body 25 abuts on the valve seat 260 of the electromagnetic valve 2, the liquid on the inflow side and the liquid on the outflow side of the electromagnetic valve 2 including the flow paths of the joint unit 1 are electrically insulated. The structure may be such that, at the time of the valve-closed state, the liquid on the inflow side and the liquid on the outflow side of the electromagnetic valve 2 are electrically conductive via the component parts of the electromagnetic valve 2 and/or the component parts of the joint unit 1. In this case, in comparison with the magnitude of electrical resistance via these component parts, whether the electrical resistance of the liquid is sufficiently small or not will be a matter. It is required that the magnitude of electrical resistance via the component parts of the electromagnetic valve 2 and/or the joint unit 1 is a magnitude to the extent that the electrical resistance of the liquid can be handled as a finite value. Furthermore, it is preferable that the magnitude of electrical resistance via the component parts of the electromagnetic valve 2 and/or the component parts of the joint unit 1 is sufficiently large compared with the electrical resistance of the liquid (electrical conductance of the component parts of the electromagnetic valve 2 and/or the component parts of the joint unit 1 should be negligible with reference to the electrical conductance of the liquid).

In this case, even with the structure as described above in which the liquid on the inflow side and the liquid on the outflow side of the electromagnetic valve 2 are electrically conductive via the component parts of the electromagnetic valve 2 and/or the joint unit 1, an index value indicating a degree of electrical conductivity such as electrical resistance between both can be measured. And, liquid leakage or the like can be detected based on changes of this index value.

While the electromagnetic valve 2 is exemplarily described as a fluid device in the present embodiment, a configuration in which liquid leakage is detected by measuring a degree of electrical conductivity between the liquid on the inflow side and the liquid on the outflow side can be applied to any of various fluid devices, such as a manual valve, a valve using a stepping motor, and a three-way valve or four-way valve which switches a flow path.

In the present embodiment, a configuration is exemplarily described in which the detection circuit 10 determines whether liquid leakage is present or absent by the threshold process regarding the voltage value of the detection signal. In place of this, the flow rate of the liquid may be measured in accordance with the magnitude of the voltage value of the detection signal. Also, for example, when the electromagnetic valve 2 is driven by duty control in which opening and closing are cyclically repeated, the flow rate may be calculated by estimating a degree of valve opening based on a temporal average value of voltage values of the detection signal. The flow rate may also be calculated by estimating a degree of valve opening from a ratio between a period in which the voltage value of the detection signal is Hi and a period in which it is Lo.

Furthermore, the detection circuit 10 may be provided with a threshold setting part for appropriately setting the threshold value to be applied to the above-described threshold process. As threshold setting methods by this threshold setting part, the following methods can be thought, for example.

### (First Setting Method)

A method of setting the threshold value by multiplying, by a coefficient, a magnitude (voltage value) of the detection signal when the electromagnetic valve 2 is closed. As this coefficient, for example, a value exceeding 1.0 can be set, such as 1.1 or 1.2.

### (Second Setting Method)

A method of setting the threshold value by multiplying, by a coefficient, the magnitude (voltage value) of the detection signal when the electromagnetic valve 2 is open. As this coefficient, for example, a value such as 1/10 or 1/100 can be set.

### (Third Setting Method)

A method of setting the threshold value by multiplying, by a coefficient, a value obtained by dividing the magnitude (voltage value) of the detection signal when the electromagnetic valve 2 is closed by the magnitude (voltage value) of the detection signal when the electromagnetic valve 2 is open. As this coefficient, for example, a value exceeding 1.0 can be set, such as 1.1 or 1.2. A target for the threshold process in this case is a value obtained by dividing the magnitude of the target detection signal by the magnitude (voltage value) of the detection signal when the electromagnetic valve 2 is open.

Note that the threshold process using the threshold value set as described above may be a process by a digital circuit or a process by an analog circuit.

As for the function of the signal processing part 103 which amplifies the detection signal in alternating current occurring at the electrodes 14, a plurality of types of amplification factors may be provided. While there is a possibility that a faint detection signal may be overlooked if the amplification factor is small including an amplification factor of 1, if the amplification factor is large, saturation may occur when a large detection signal occurs. When a plurality of types of amplification factors are provided, processing can be performed by selecting the detection signal of which the magnitude after amplification is in an appropriate range. Such configuration is effective when the electrical conductance of the liquid to be handled is unknown or varies, and is useful in improving versatility.

Note that in the present embodiment, a voltage-value detection signal is exemplarily described as the detection signal that is generated by the signal processing part 103 for use in liquid leakage determination by the determination part 105. With the voltage-value detection signal, for example, even if this detection signal is outputted as it is to the drive unit 8, handling on a reception side is relatively easy, and the circuit structure for handling the detection signal can be simplified.

A part may be provided which outputs the detection signal of the signal processing part 103 or the leak signal of the detection circuit 10 to the outside not directly connected via a signal line or the like. For example, if the signal is outputted to a communication channel network such as the Internet via a wireless LAN or the like, the operating state of the electromagnetic valve 2 can be monitored from outside.

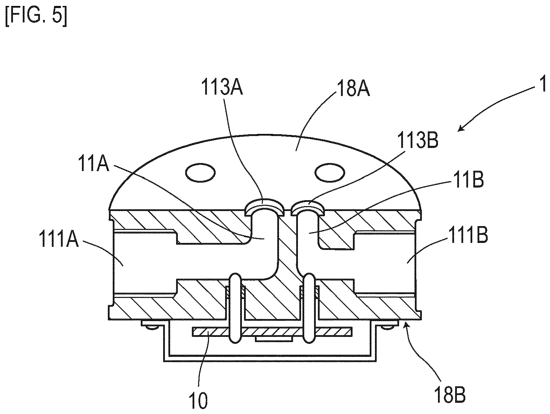

While the joint system 1S with the detection circuit 10 provided as a separate body to the joint unit 1 is exemplarily described in the present embodiment, the detection circuit 10 may be incorporated into the joint unit 1 as in FIG. 5. In this case, it is not required to connect the joint unit 1 and the detection circuit 10 via an electric wire or the like, and handling in an integrated manner is facilitated.

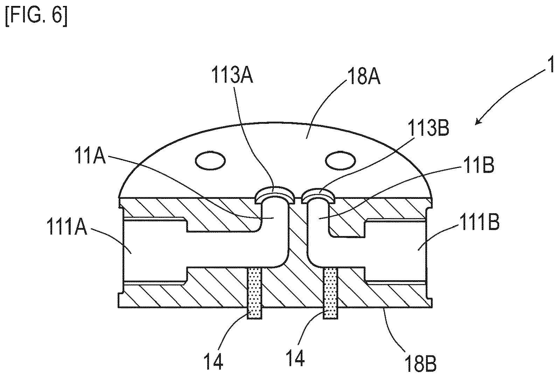

In the present embodiment, the joint unit 1 with the metal-made electrodes 14 fitted into the attachment holes 140 are exemplarily described. The electrodes 14 may be provided by insert molding. Alternatively, as in FIG. 6, for example, the joint unit 1 may be fabricated by two-color molding by a first resin material having conductivity and a second resin material having electrical insulation. It is preferable that, while a main body part of the joint unit 1 is formed of the above-described second resin material, electrical routes functioning as the electrodes 14 are formed of the above-described first resin material.

Furthermore, a rubber with a conductive material such as carbon nanotube blended therein to enhance conductivity may be adopted as an electrode. The electrode made of rubber may be arranged, for example, in a resin material by insert molding or the like, or may be press-fit or the like into the attachment hole 140 provided to be bored in advance. In the case of press-fitting, since the electrode made of rubber is moderately deformed to function as a seal material, it is not required to separately provide a seal material in addition to the electrode, and the number of parts can be reduced.

As a mode of the joint system 1S, in addition to the mode as described above in the present embodiment in which the joint unit 1 having a function as a joint is combined with the detection circuit 10, various modes can be thought, such as a mode in which the joint unit 1 incorporates the detection circuit 10, and a mode with a joint unit 1 alone that is capable of combining an external circuit device having functions similar to that of the detection circuit 10.

In the present embodiment, exemplarily described is the fluid device (electromagnetic valve 2) in the structure in which, at the time of the valve-closed state, the liquid is accumulated on the upstream side of the valve seat 260 and also accumulated to reside on the downstream side. In this fluid device, the state becomes such that, at the time of the valve-closed state, the first electrode 141 is immersed in the liquid on the inflow side and the second electrode 142 is immersed in the liquid on the outflow side. Among fluid devices, there is a device in which, at the time of the valve-closed state, the liquid on the downstream side of the valve is discharged to cause the flow path to become empty. In the case of this fluid device, the first electrode 141 and the second electrode 142 may be both provided to the outflow side. When liquid leakage is present at the time of the valve-closed state, the electrical resistance between the electrodes 141 and 142 decreases, and therefore liquid leakage can be detected. Also, in the case of a fluid device such as a pipe or tube in which while the flow path is filled with the liquid in a liquid flowing state, the liquid is discharged from the flow path to cause the flow path to become empty in a state in which the liquid does not flow, the first electrode 141 and the second electrode 142 are preferably provided in the flow paths without distinction between the inflow side and the outflow side. For example, both of the electrodes 141 and 142 may be provided on the outflow path side. By the electrical resistance between the electrodes 141 and 142 or the like, it is possible to determine whether the state is such that the liquid is flowing or not. In this case, the first electrode 141 and the second electrode 142 may be at the same position or different positions in a direction in which the liquid flows.

### (Second Embodiment)

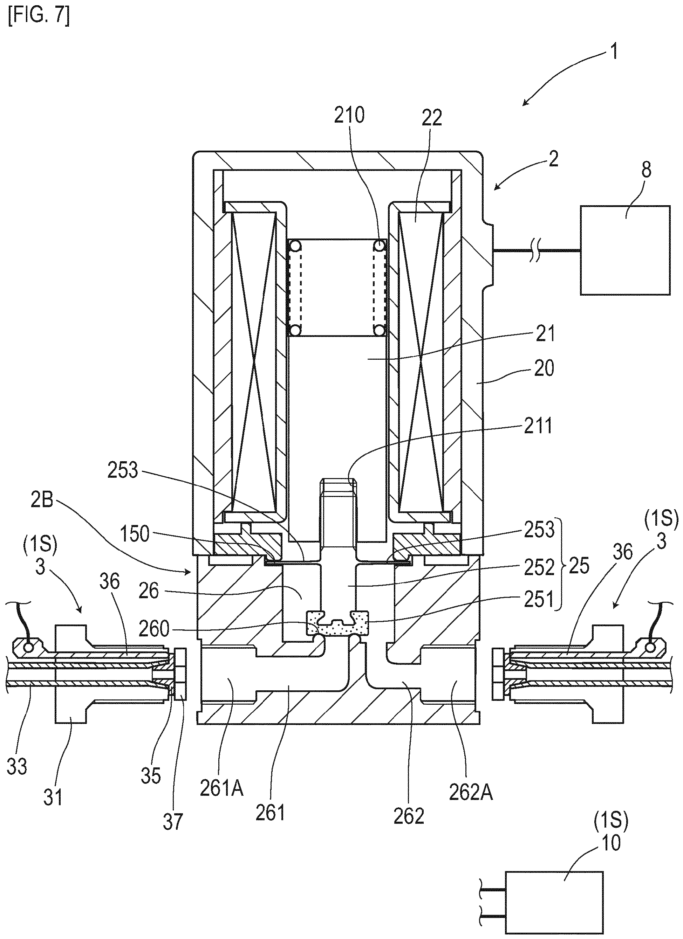

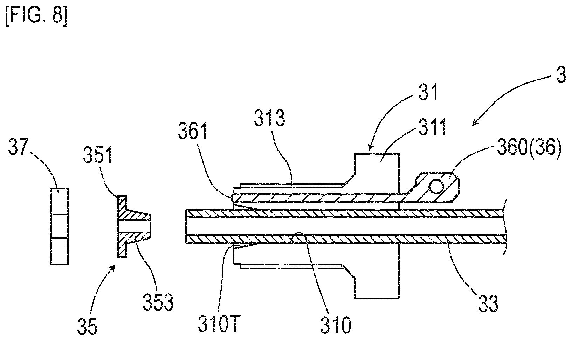

The present embodiment is an example of the joint system 1S including a separate joint 3 for each flow path in place of the joint unit of the first embodiment. Details of this are described with reference to FIG. 7 and FIG. 8.

A fluid device as a target to which the joint system 1S of the present embodiment is applied is the electromagnetic valve 2 similar to that in the first embodiment. In the electromagnetic valve 2 of the present embodiment, the flow path on the inflow side and the flow path on the outflow side communicate with opening parts 261A and 262A provided to be bored in the outer circumferential surface of the columnar flow path part 2B. In each of these opening parts 261A and 262A, a screw thread is formed to allow the joint 3 having an electrode 36 to be individually connected thereto.

The joint 3 is a joint configured to include, as depicted in FIG. 8, a joint body 31 which has a tube 33 made of PTFE (Poly Tetra Fluoro Ethylene) forming a flow path arranged and inserted therein, a metal-made metal sealer 35, a soft sealer 37 made of rubber, and so forth.

The joint body 31 is a resin-molded product which assumes an outer shape similar to that of a bolt and is provided with a through hole 310. In the joint body 31, a head portion 311 having a hexagonal cross-sectional shape is provided at one end portion where a tool such as a wrench is hooked, and a screw thread 313 is formed on the outer circumferential surface of another portion. Opposite to the head portion 311, the through hole 310 of the joint body 31 has a tapered opening end portion 310T with its diameter gradually enlarged toward an opening side.

In the joint body 31, a pin-shaped electrode 36 provided with a connector portion 360 at a rear end is provided to be buried by insert molding. The electrode 36 has a tip face 361 exposed so as to be substantially flush with an end face of the joint body 31 and has the connector portion 360 at the rear end protruding to the outside from the head portion 311 of the joint body 31.

The metal sealer 35 is a metal-made seal part with an annular flange portion 351 combined with a cylindrical portion 353 with a smaller-diameter, and has conductivity. The cylindrical portion 353 is formed in a tapered shape with an outer diameter gradually decreased toward its distal end. This tapered cylindrical portion 353 is inserted into the tapered opening end portion 310T of the joint body 31 in a state with the tube 33 externally arranged and fitted.

The soft sealer 37 is a rubber-made or PTFE-made seal part having an annular shape with the next larger diameter than that of the flange portion 351 of the metal sealer 35. When the joint body 31 having the metal sealer 35 assembled thereto is connected to the opening part 261A/262A, the soft sealer 37 is arranged at a distal end side to be pressed against the bottom surface of the opening part 261A/262A.

When the joint 3 is connected to the electromagnetic valve 2, the tapered cylindrical portion 353 of the metal sealer 35 is first inserted into a distal end of the tube 33 arranged to penetrate through the joint body 31. Then, the joint body 31 combined with the metal sealer 35 as described above is screwed into the opening part 261A/262A of the electromagnetic valve 2 with the soft sealer 37 arranged on the bottom side.

When the joint body 31 is screwed into the opening part 261A/262A, the metal sealer 35 at the distal end is pressed onto the soft sealer 37. The soft sealer 37 is nipped between the bottom surface of the opening part 261A/262A and the metal sealer 35 to cause moderate elastic deformation, thereby forming a fluid-tight seal surface on both of front and back sides of the soft sealer 37.

When the joint body 31 is screwed, the tapered cylindrical portion 353 of the metal sealer 35 is pressed into the tapered opening end portion 310T of the joint body 31, and the flange portion 351 of the metal sealer 35 is pressed against the distal end surface of the joint body 31. Between the cylindrical portion 353 and the opening end portion 310T, the PTFE-made tube 33 is moderately compressed and deformed, and its inner circumferential surface is pressed onto the outer circumferential surface of the cylindrical portion 353 to form a fluid-tight seal surface. The flange portion 351 of the metal seal 35 is pressed onto the distal end face of the joint body 31, thereby bringing about a state of making electrical contact with the tip face 361 of the electrode 36 exposed to the distal end face of the joint body 31.

The joint 3 has a structure in which the metal sealer 35 forms a part of the flow path of the liquid and the liquid contacts with its inner circumferential surface. In this joint 3, the flange portion 351 of the metal sealer 35 is in electrical contact with the electrode 36, and the liquid flowing through the joint 3 and the electrode 36 are in a state of being electrically connected. When the joint 3 is connected to each of the opening parts 261A and 262A, the degree of electrical conductivity between the liquid on the inflow side and the liquid on the outflow side of the electromagnetic valve 2 can be detected using the electrode 36 of each joint 3.

As a mode of the joint system 1S of the present embodiment, in addition to a mode including a detection circuit (a circuit similar to the detection circuit of the first embodiment) not depicted in at least two joints 3, a mode configured of at least two joints 3 and capable of being combined with an external detection circuit may be adopted.

Note that other structures, operations, and effects are similar to those of the first embodiment.

### (Third Embodiment)

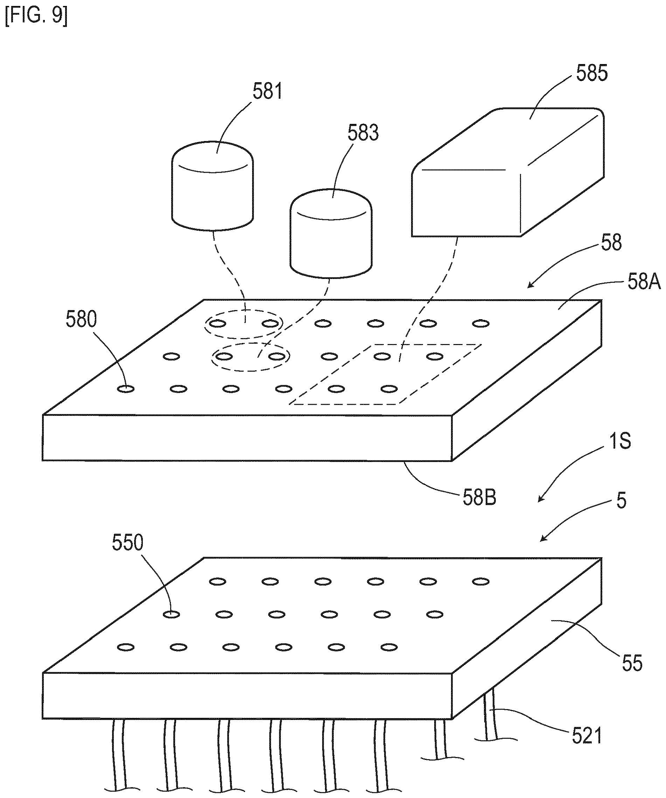

The present embodiment is an example of the joint system 1S including a joint unit 5, which is obtained by, based on the joint unit of the first embodiment, changing the structure so as to be attachable to a manifold 58 as a fluid device capable of closing and switching flow paths. Details of this are described with reference to FIG. 9 to FIG. 11.

The manifold 58 exemplarily described in FIG. 9 is a manifold having a plate shape, with a plurality of flow paths provided to a resin-made flat plate. In both of the front and back surfaces of the manifold 58, a plurality of opening holes 580 for flow paths are provided to be bored. An installation surface 58A as one surface is a surface on a side where devices such as an electromagnetic valve 581, a four-way valve 585, and a pump 583 are attached. The opening holes 580 in this surface are holes for supplying the liquid to these devices or circulating the liquid flowing out from these devices. In this manifold 58, the function of the manifold 58 can be changed in accordance with the type of device to be attached to the installation surface 58A and/or the location of attachment.

A coupling surface 58B of the manifold 58 opposite to the installation surface 58A is a surface where the flat-plate-shaped joint unit 5 is attached as being laminated. On the coupling surface 58B, a plurality of coupling holes, not depicted, communicating with the opening holes 580 of the installation surface 58A are open. These coupling holes are coupled to flow paths 550 that are open on the surface of the joint unit 5.

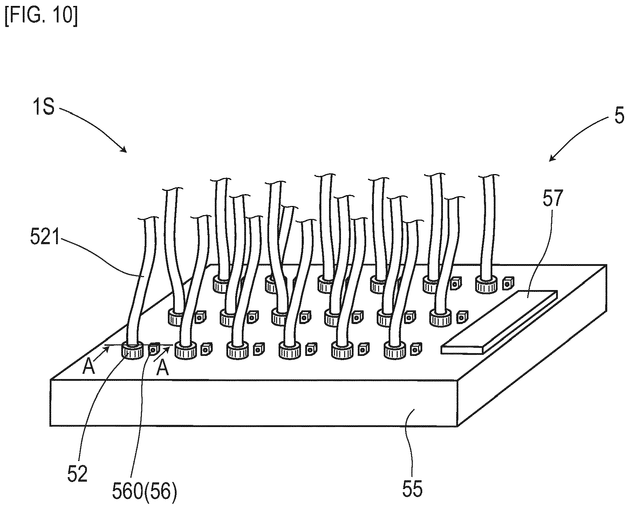

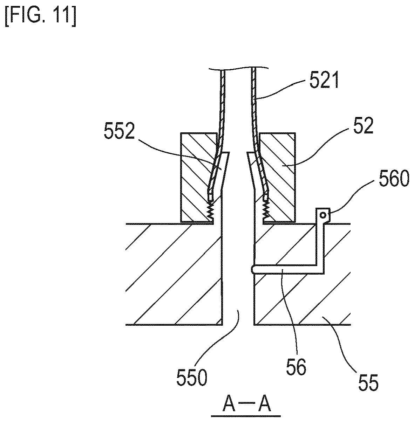

The joint unit 5 is, as in FIG. 9 and FIG. 10, a unit including a resin-made, flat-plate-shaped joint plate 55 with the plurality of flow paths 550 (FIG. 11) provided to be bored. In the joint unit 5, the flow paths 550 for being coupled to the coupling holes provided to be bored in the coupling surface 58B of the manifold 58 are formed. From these flow paths 550, tubes 521 are provided to extend. Of both surfaces of the joint plate 55, to a surface on a side where the tubes 521 are connected, a detection circuit 57 is attached.

On the surface of the joint plate 55, as in FIG. 11, a nipple 552 having a tapered tip portion and provided with a screw portion at an intermediate portion is provided to stand for each flow path 550. In the joint unit 5, a fastening nut 52 is screwed into the nipple 552 having the tube 521 externally arranged and fitted to the tapered tip portion, thereby causing the tube 521 to be connected in a fluid-tight manner to each flow path 550.

As in the cross-sectional view of FIG. 11, in the joint plate 55, a hook-shaped electrode 56 provided with a connector portion 560 at one end portion is provided to be buried so as to correspond to each flow path 550. Each electrode 56 provided to be buried by insert molding has a tip opposite to the connector portion 560 exposed to an inner circumferential wall surface of the flow path 550 and has the connector portion 560 at the other end protruding from the surface of the joint plate 55 corresponding to an outer circumferential side of the nipple 552. Each connector portion 560 is electrically connected to the detection circuit 57 via a signal line not depicted. In the joint system 1S of FIG. 10 and FIG. 11, by changing the combination of the connector portions 560 as appropriate, the combination of the flow paths 550 as targets for measuring the degree of electrical conductivity between the liquids can be switched.

For example, as in FIG. 9, with an inflow port and an outflow port of the electromagnetic valve 581 as a device being connected to two adjacent opening holes 580 of the installation surface 58A, the tube 521 provided to extend from the flow path 550 corresponding to the opening hole 580 connected to the inflow port of the electromagnetic valve 581 serves as an inflow-side tube, and the tube 521 provided to extend from the flow path 550 corresponding to the opening hole 580 connected to the outflow port of the electromagnetic valve 581 serves as an outflow-side tube. In this case, a flow path of the inflow-side tube 521 → the flow path 550 → the electromagnetic valve 581 → the flow path 550 → the outflow-side tube 521 is formed. And, a "joint system" is formed, with two electrodes 56 disposed in that flow path on the inflow side and the outflow side across the electromagnetic valve 581.

Conventionally, there is a problem in which when an anomaly occurs in a system of a fluid device such as the manifold 58 where a plurality of valves or switch valves are arranged, it is difficult to specify a location of occurrence of the anomaly such as leakage and the location where leakage is occurring is hardly found. On the other hand, when the joint system 1S of the present embodiment is applied, when an anomaly such as leakage occurs in the manifold 58, it is easy to specify the anomaly occurrence location and maintenance work such as replacement of a valve relevant to the anomaly occurrence location can be quickly and appropriately performed.

Note that other structures, operations, and effects are similar to those of the first embodiment.

### (Fourth Embodiment)

The present embodiment is an example obtained by changing, based on the joint system of the first embodiment, the details of signal processing to be performed by the detection circuit 10 to improve accuracy of leakage detection. Details of this are described with reference to FIG. 4, FIG. 12, and FIG. 13.

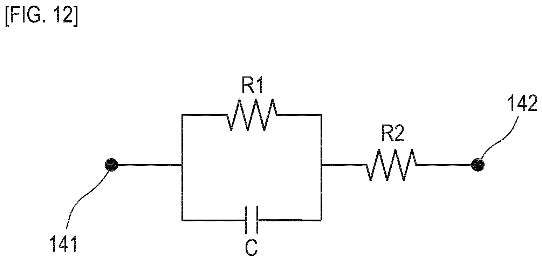

Prior to description of the configuration of the present embodiment, an electrical route between the first electrode 141 and the second electrode 142 is first described. In the electrical route between the first electrode 141 and the second electrode 142, due to the presence of an interface where the electrodes 141 and 142 make contact with the liquid and so forth, stray capacitance causing electrical action similar to that of a capacitor as an electronic part which accumulates electric charges, electrical resistance, and so forth are present. The electrical route between the first electrode 141 and the second electrode 142 can be represented by an equivalent circuit as in FIG. 12. In this equivalent circuit, a resistance R1 is an electrical resistance of the route between electrodes 141 and 142 with the liquid, the electromagnetic valve, and so forth intervened therebetween. A capacitance C is a stray capacitance between the electrodes 141 and 142. A resistance R2 is an electrical resistance caused by internal resistance of the electrode 141 and 142, electric wiring, and so forth. Note that a stray capacitance not depicted is present also at the above-described internal resistance and electric wiring.

When the capacitance C is present between the electrodes 141 and 142, in response to positive-negative switching of the AC voltage (AC signal) to be applied to the first electrode 141, a slight current occurs at the second electrode 142 for charging and discharging the capacitance C. Also, the directions of the current occurring at the second electrode 142 are in opposite directions in the cases when the AC signal is changed from positive to negative and when the AC signal is changed from negative to positive. Therefore, even at the time of normal valve closing of the electromagnetic valve, when the AC signal is acted onto the first electrode 141, an AC current (intermediate signal) occurs at the second electrode 142. With this, even in a normal valve-closed state without liquid leakage, the detection signal indicating the amplitude of the intermediate signal does not become zero, and this may cause an occurrence of erroneous detection of liquid leakage.

In the first embodiment described here above, to generate the detection signal indicating the magnitude of the amplitude of the intermediate signal (AC voltage) occurring on the second electrode 142 side, the peak-hold circuit which holds the maximum value of the intermediate signal, the peak-hold circuit which holds the minimum value of the intermediate signal, and so forth are used. And, the differential value between the maximum value and the minimum value of the intermediate signal is obtained by the differential circuit, and a voltage value corresponding to this differential value is taken as the detection signal. As described above, since the intermediate signal has an amplitude even at the time of valve closing of the electromagnetic valve, the detection signal does not become zero. Therefore, in the configuration of the first embodiment, the degree of difficulty in distinguishing whether the detection signal is a signal generated due to liquid leakage or in a normal valve-closed state is high. At the time of leakage detection, to inhibit erroneous detection under a normal valve-closed state, it is required to set the threshold value when the threshold process is applied to the detection signal (voltage value), taking into account the magnitude of the detection signal in a normal valve-closed state.

By contrast, in the present embodiment, a differential value between measurement values at two measurement points in time appropriately set is taken as the detection signal, and thus the magnitude of the detection signal in a normal valve-closed state is approximately zero. With this, it is easy to set the threshold value to be applied to the threshold process at the time of leakage detection, and accuracy of leakage detection is improved by the appropriate threshold setting. In the following, a method of setting measurement points in time in the present embodiment is described.

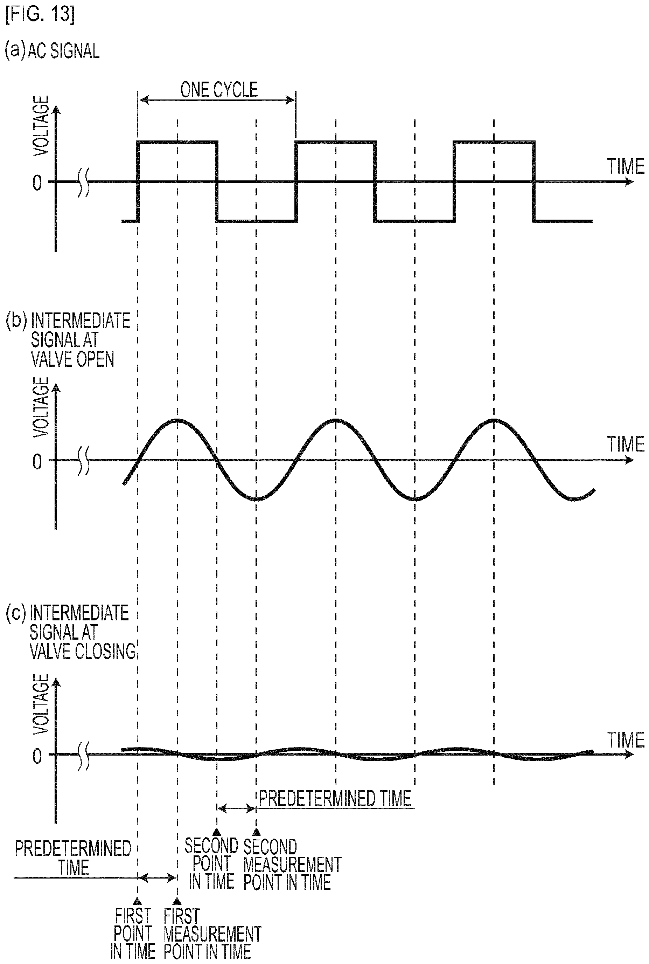

The resistance R1 in the equivalent circuit of FIG. 12 significantly fluctuates depending on whether the electromagnetic valve is in a valve-open state or valve-closed state. In a valve-open state, the electrodes 141 and the electrodes 142 make contact with each other via intervention of the liquid in the flow path, and the resistance R1 is thus decreased. On the other hand, in a valve-closed state, the liquid on the upstream side and the liquid on the downstream side are divided by the electromagnetic valve, and the resistance R1 is thus increased. This magnitude of the resistance R1 affects the phase of the intermediate signal on the second electrode 142 side. When a comparison is made between the intermediate signal in a state in which the resistance R1 is sufficiently large at the time of valve closing and the intermediate signal in a state in which the resistance R1 is small at the time of valve open, a phase difference of 90 degrees occurs (refer to FIG. 13). When R1 at the time of valve open is denoted as RLo, R1 at the time of valve closing is denoted as R1c, and a reactance value by interelectrode capacitance is denoted as Xc, a condition for occurrence of the phase difference of 90 degrees is R1c >> Xc >> RLo.

When the phase difference between the intermediate signal at the time of valve open (FIG. 13(b)) and the intermediate signal at the time of valve closing (FIG. 13(c)) is 90 degrees, the intermediate signal at the time of valve closing is zero when the intermediate signal at the time of valve open has a maximum value, and the intermediate signal at the time of valve closing is zero when the intermediate signal at the time of valve open has a minimum value. Thus, in the configuration of the present embodiment, two points where the intermediate signal at the time of valve open has the maximum value and the minimum value are set as measurement points in time so that the detection signal at the time of valve closing (voltage value indicating the magnitude of the amplitude of the intermediate signal) is zero.

On the other hand, as depicted in FIG. 13, a phase shift of the intermediate signal at the time of valve closing with respect to the AC voltage (AC signal of FIG. 13(a)) to be applied to the first electrode 141 is approximately 90 degrees. Therefore, the above-described two measurement points in time are in combination of a first measurement point in time after a lapse of a predetermined time corresponding to a 1/4 cycle with reference to a first point in time when a square-wave AC signal is switched from negative to positive and a second measurement point in time after a lapse of the predetermined time corresponding to the 1/4 cycle with reference to a second point in time when the AC signal is switched from positive to negative. And, in the present embodiment, a differential value between a first measurement value indicating the magnitude of the intermediate signal at the first measurement point in time and a second measurement value indicating the magnitude of the intermediate signal at the second measurement point in time is taken as the detection signal.

According to the configuration of the present embodiment, at the time of valve closing of the electromagnetic valve, the magnitude of the detection signal becomes zero even if the intermediate signal when an AC voltage (AC signal) is applied to the first electrode 141 has an amplitude. On the other hand, when liquid leakage occurs at the time of valve closing of the electromagnetic valve, the intermediate signal become close to one at the time of valve open, and thus the absolute values of the intermediate signals at the above-described first and second measurement points in time increase, and accordingly the value of the detection signal indicating the differential value increases. Therefore, in the configuration of the present embodiment, by applying, for example, the threshold process with the threshold value close to zero to the magnitude of the detection signal, liquid leakage can be detected with high accuracy.

Furthermore, in the present embodiment, the configuration is adopted in which the magnitude of the intermediate signal is measured at two measurement points in time and a difference is taken to generate the detection signal. With this configuration, a peak-hold circuit is not required, and thus the circuit structure of the detection circuit 10 can be simplified, and cost reduction is easy.

Note that when the above-described intermediate signal (AC voltage) is generated, a band-pass filter is preferably applied to remove low-frequency components and high-frequency components. The frequential characteristics of this band-pass filter are preferably set so as to correspond to the frequency of the AC signal generated by the signal generation part 321. For example, when the AC signal cyclically changing with a frequency of 1 KHz is acted onto the electrode 141, a band-pass filter which selectively passes through signals of frequency near 1 kHz is preferably adopted.

Also, in the present embodiment while the square wave is exemplarily described as the AC signal (AC voltage) to be applied to the first electrode 141, the AC signal may be a sine wave or the like.

Note that other structures, operations, and effects are similar to those of the first embodiment.

### (Fifth Embodiment)

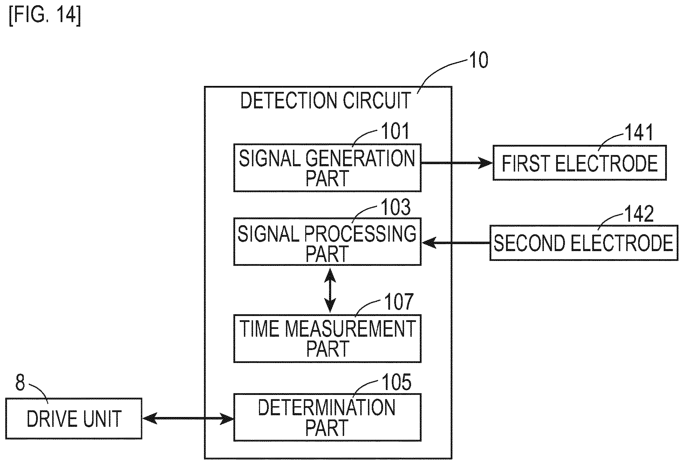

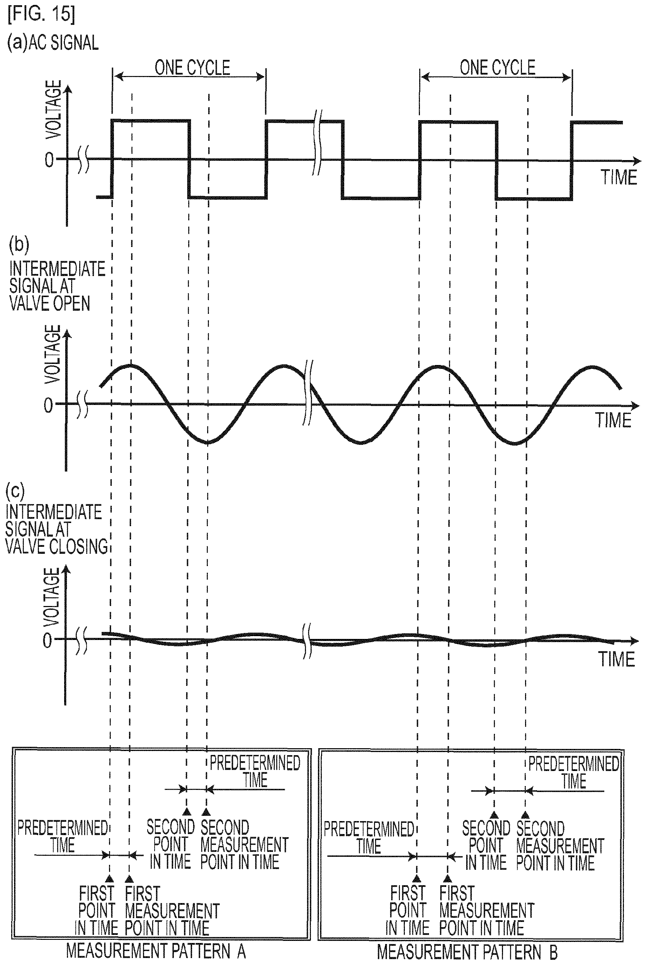

The present embodiment is an example obtained by changing, based on the configuration of the fourth embodiment, settings of measurement points in time of the intermediate signal for generating the detection signal. Details of this are described with reference to FIG. 14 and FIG. 15.

While the phase difference between the AC voltage (AC signal) to be applied to the first electrode 141 and the intermediate signal at the time of valve closing is approximately 90 degrees, the phase shift of the intermediate signal at the time of valve open with respect to the AC voltage (AC signal) to be applied to the first electrode 141 may fluctuate up to 90 degrees exemplarily described in the fourth embodiment.

In the present embodiment, as depicted in FIG. 14, a time measurement part 107 for measuring a shift time corresponding to the above-described phase shift is added to the detection circuit 10 which detects liquid leakage. As in FIG. 15, when the electromagnetic valve is in a valve-open state, with reference to the first point in time when the AC voltage (AC signal) to be applied to the first electrode 141 is switched from negative to positive or the second point in time when it is switched from positive to negative, the time measurement part 107 measures a shift time until the intermediate signal reaches a maximum value or minimum value. The time measurement part 107 specifies a point in time when the signal reaches the maximum value and a point in time when the signal reaches the minimum value by, for example, repeating measurement of the intermediate signal in a cycle sufficiently quicker than 1 kHz, which is the frequency of the AC signal, thereby measuring the above-described shift time.

In the configuration of the present embodiment, this shift time is handled as a predetermined time for setting measurement points in time. As in FIG. 15, with reference to the first point in time when the AC voltage (AC signal) to be applied to the first electrode 141 is switched from a negative value to a positive value, a point in time shifted by the above-described shift time is set as the first measurement point in time and, with reference to the second point in time when the AC voltage is switched from a positive value to a negative value, a point in time shifted by the above-described shift time is set as a second measurement point in time. And, the first measurement value of the intermediate signal at the first measurement point in time is acquired and the second measurement value of the intermediate signal at the second measurement point in time is acquired, and the differential value between the first and second measurement values is taken as the detection signal.

Although the phase shift between the intermediate signal when the electromagnetic valve is open and the intermediate signal when the electromagnetic valve is closed is not 90 degrees (refer to FIG. 15), the detection signal can be made at maximum at the first measurement point in time when the intermediate signal at the time of valve open has the maximum value and the second measurement point in time when it has the minimum value (a measurement pattern A in FIG. 15). On assumption that the noise level is at random and approximately constant, when the above-described first measurement point in time and the above-described second measurement point in time are set, a signal ratio with respect to noise (S/N ratio) can be maximized.

In the present embodiment, points in time of the maximum value and the minimum value of the intermediate signal at the time of valve open are set as measurement points in time (measurement pattern A in FIG. 15). For example, under a condition in which the noise level is relatively low and does not affect determining valve open and valve closing, a point in time when the intermediate signal at the time of valve closing is switched from positive to negative to cross zero can be set as the first measurement point in time and a point in time when it crosses from negative to positive can be set as the second measurement point in time (measurement pattern B in FIG. 15). Thereby, the detection signal in accordance with a degree of leakage can be acquired with high accuracy from a valve-closed state.

As described above, according to the configuration of the present embodiment, even if the phase shift of the intermediate signal (at the time of valve closing) with respect to the AC voltage (AC signal) to be applied to the first electrode 141 is shifted from 90 degrees, a measurement point in time of the intermediate signal can be appropriately set. Thereby, it is possible to make the magnitude of the detection signal at the time of valve closing close to zero.

Note that other structures, operations, and effects are similar to those of the fourth embodiment.

While specific examples of the present invention have been described in detail as the embodiments, these specific examples each merely disclose one example of technology included in the claims. While application to a fluid device in which a device such as a valve intervenes a flow path is exemplarily described in the embodiments, application may be made also to a fluid device in which a device such as a pump or switch valve intervenes a flow path, or to a fluid device with a flow path not provided with a device such as a valve, pump, or switch valve. Furthermore, it is needless to say that the claims should not be restrictively construed by the structure, numerical values, and so forth of the specific examples. The claims include technologies acquired by variously modifying, changing, or combining the above-described specific examples as appropriate by using known technology, knowledge of people skilled in the art, and so forth.

### REFERENCE SIGNS LIST

- 1, 5: joint unit
- 1S: joint system
- 10, 57: detection circuit (circuit)
- 11A, B: flow path
- 14, 36, 56: electrode
- 141: first electrode
- 142: second electrode
- 2: electromagnetic valve (fluid device)
- 21: plunger
- 22: coil
- 25: valve body
- 260: valve seat
- 3: joint
- 55: joint plate
- 58: manifold

## Claims

1. A joint system comprising:
flow paths coupled to a fluid device which handles a fluid; and
electrodes separately provided to at least two of the flow paths to electrically make contact with the fluid in the flow paths, wherein
the system is configured so as to be able to measure a degree of electrical conductivity between fluids in different flow paths by using the electrodes separately provided to said at least two of the flow paths.

2. The joint system in claim 1, wherein said at least two of the flow paths are integrally provided and configured to be attachable to the fluid device.

3. The joint system in claim 1 or 2, comprising a circuit which detects an amount of the fluid passing through the fluid device or whether the fluid is present or absent in accordance with the degree of electrical conductivity.

4. The joint system in claim 3, wherein the circuit includes a signal generation part which applies, between a first electrode and a second electrode provided to different flow paths, a voltage of an alternating square-wave in which a voltage of a positive value and a voltage of a negative value are cyclically and alternately switched, a signal processing part which acquires a measurement value indicating a magnitude of a current between the first electrode and the second electrode, and a determination part which determines the amount of the fluid passing through the fluid device or whether the fluid is present or absent.

5. The joint system in claim 4, wherein the signal processing part acquires a first measurement value at a point in time shifted by a predetermined time with reference to a first point in time when the voltage to be applied by the signal generation part is switched from a negative value to a positive value, and acquires a second measurement value at a point in time shifted by the predetermined time with reference to a second point in time when the voltage to be applied by the signal generation part is switched from a positive value to a negative value, and
the circuit measures a magnitude of a differential value between the first measurement value and the second measurement value as an index indicating the degree of electrical conductivity.

6. The joint system in claim 5, wherein the circuit includes a time measurement part which measures a shift time until the measurement value acquired by the signal processing part reaches a maximum value or minimum value after the first or second point in time in a state in which the fluid passes through the fluid device, and sets the shift time as the predetermined time.

7. The joint system in claim 5 or 6, wherein the determination part is configured to perform a threshold process on the differential value to detect whether the fluid passing through the fluid device is present or absent, and
the circuit includes a threshold setting part which sets a threshold value to be applied to the threshold process.

8. The joint system in any one of claims 1 to 7, wherein the flow path has electrical insulation properties ensured with respect to the fluid, and the electrodes have electrical insulation properties ensured with respect to the fluid device.
